# EUROPÄISCHE PATENTSCHRIFT

(11) **EP 1 413 184 B1**
(45) Veröffentlichungstag und Bekanntmachung des Hinweises auf die Patenterteilung: **21.09.2005**
(21) Anmeldenummer: 02767264.1
(22) Anmeldetag: 26.07.2002
(51) Int. Cl.: H05K 13/04

(54) **VERFAHREN ZUM PRÜFEN EINES CHIPS MIT EINEM GEHÄUSE UND ZUM BESTÜCKEN EINER PLATINE MIT DEM GEHÄUSE**
METHOD FOR TESTING A CHIP WITH A HOUSING AND FOR PLACING SAID HOUSING ON THE BOARD
PROCEDE D'ESSAI D'UNE PUCE POURVUE D'UN BOITIER ET DE MISE EN PLACE DU BOITIER SUR UNE CARTE DE CIRCUIT IMPRIME

(30) Priorität: 27.07.2001 DE 10136578
(43) Veröffentlichungstag der Anmeldung: 28.04.2004
(73) Patentinhaber: Micronas GmbH, 79108 Freiburg (DE)
(72) Erfinder: HAUSER, Wolfgang, 79346 Endlingen (DE); DREHER, Heiko, 79287 Winden (DE); KIMSTEDT, Christian, 79111 Freiburg (DE); ROGALLA, Markus, 79189 Bad Krozingen (DE)
(74) Vertreter: Patentanwälte Westphal, Mussgnug & Partner
(86) Internationale Anmeldenummer: PCT/EP2002/008369
(87) Internationale Veröffentlichungsnummer: WO 2003/013210

(56) Entgegenhaltungen:
- DE-A- 3 738 164
- US-A- 3 416 348
- US-A- 4 557 043
- US-A- 5 585 281
- US-A- 5 675 884
- TELEFUNKEN, DATENBLATT TCA 830 -TCA830A

## Beschreibung

Die Erfindung betrifft ein Verfahren zum Prüfen eines Chips mit einem Gehäuse und zum Bestücken einer Platine mit dem Gehäuse gemäß dem Oberbegriff des Patentanspruchs 1. Weiterhin betrifft die Erfindung einen Chip mit einem Gehäuse gemäß dem Oberbegriff des Patentanspruchs 7.

Um die Abmessungen des Gehäuses für einen Chip mit zahlreichen Anschlussbeinchen, z. B. 88, klein zu halten, werden die Anschlussbeinchen des Gehäuses möglichst dicht nebeneinander angeordnet. Ein Mindestabstand darf jedoch nicht unterschritten werden, weil die Abstände der zugehörenden Bohrungen auf einer Platine zum Einstecken der Anschlussbeinchen nicht beliebig verringerbar sind. Je kleiner die Abstände der Bohrungen und Leiterbahnen auf der Platine gewählt werden, desto teurer und aufwendiger gestaltet sich die Herstellung einer Platine. Zudem besteht bei kleinen Bohrabständen auf der Platine die Gefahr, daß beim Lötvorgang die Anschlussbeinchen kurzgeschlossen werden.

Eine Möglichkeit, die Abstände der Bohrungen auf der Platine zu vergrößern, liegt darin, die Anschlussbeinchen des Gehäuses durch Biegen eines Teils der Anschlussbeinchen oder beispielsweise jedes zweiten Anschlussbeinchens nach innen versetzt anzuordnen. Dem Vorteil größerer Abstände der Bohrungen auf der Platine stehen aber als Nachteile das Erfordernis spezieller Testsockel zum Prüfen der Chips und aufwendiger Verpackungsmittel gegenüber. Insbesondere sind die Verpackungsmittel so zu gestalten, dass die Anschlussbeinchen nicht aus ihrer genau gerichteten Lage verbogen werden.

Aus der DE 37 38 164 A1 ist ein Verfahren zum Prüfen eines Chips mit Gehäuse bekannt. Das Datenblatt TCA830, Telefunken, offenbart einen Chip mit einem Gehäuse. Weitere Chips sind aus der US 3,416,348 und aus der US 5,675,884 bekannt und weisen die Merkmale des Oberbegriffs des Anspruches 7 auf.

Es ist daher Aufgabe der Erfindung, ein verbessertes Verfahren zum Prüfen eines Chips mit einem Gehäuse und zum Bestücken einer Platine mit dem Gehäuse sowie einen verbesserten Chip anzugeben.

Die Aufgabe wird durch den Gegenstand des Patentanspruchs 1 bzw. durch den Gegenstand des Patentanspruchs 7 gelöst.

Die Unteransprüche geben vorteilhafte Ausgestaltungen an.

Das erfindungsgemäße Verfahren sieht vor, das Gehäuse mit auf einer geraden Linie liegenden Anschlussbeinchen - Techniker verwenden hierzu häufig den Ausdruck dual inline - herzustellen und den Chip in diesem Zustand zu prüfen. Hierzu wird der Chip auf einen Testsockel gesteckt. Dies hat den ersten Vorteil, dass preisgünstig herstellbare Testsockel zum Prüfen der Chips eingesetzt werden können. Der zweite Vorteil liegt darin, dass auch preisgünstige Verpackungsmittel zum Aufbewahren und Versenden der Chips genügen. Das erfindungsgemäße Verfahren sieht weiter vor, erst unmittelbar vor dem Einstecken der Anschlussbeinchen des Gehäuses in eine Platine mindestens ein Anschlussbeinchen, vorzugsweise jedes zweite Anschlussbeinchen, mittels eines Biegewerkzeuges nach innen zu biegen, um eine versetzte Anordnung der Anschlussbeinchen zu bilden. Die Erfindung vereinigt daher die Vorteile eines Gehäuses, dessen Anschlussbeinchen auf einer geraden Linie liegen, mit denen eines Gehäuses, dessen Anschlussbeinchen versetzt angeordnet sind.

Die elektrischen Prüfungen des Chips gestalten sich einfach, weil preisgünstig herstellbare Testsockel genügen. Ebenso lassen sich Standardverpackungsmittel zum Verpacken der Gehäuse einsetzen. Ein nachträgliches Richten der Anschlussbeinchen vereinfacht sich, weil die Anschlussbeinchen nicht bereits bei der Herstellung des Gehäuses, sondern erst unmittelbar vor dem Einsetzen in die Platine versetzt gebogen werden.

Die Erfindung wird anhand der Figuren näher beschrieben und erläutert:

In der Zeichnung zeigen:
- Figur 1: ein Flußdiagramm eines Ausführungsbeispieles des erfindungsgemäßen Verfahrens mit einer Darstellung der jeweiligen Verfahrensschritte,
- Figur 2: ein Ausführungsbeispiel eines Gehäuses mit aufgesetztem Biegewerkzeug in Draufsicht,
- Figur 3: eine Frontansicht des Gehäuses aus Figur 2 mit aufgesetztem Biegewerkzeug,
- Figur 4: eine Frontansicht eines Ausführungsbeispieles eines Gehäuses mit Maßangaben,
- Figur 5: einen Ausschnitt einer Platine mit den Bohrungen für die Anschlussbeinchen mit Maßangaben und
- Figur 6: ein zweites Beispiel eines erfindungsgemäßen chips.

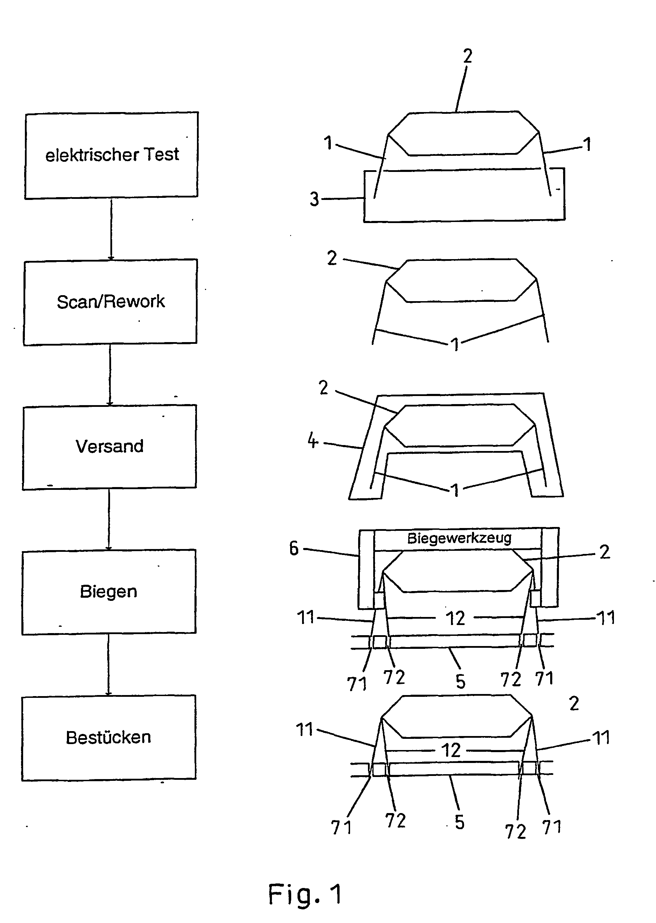

In Figur 1 ist ein Flußdiagramm des erfindungsgemäßen Verfahrens mit den einzelnen dazugehörenden Verfahrensschritten dargestellt.

Das mit auf einer geraden Linie liegenden Anschlussbeinchen 1 hergestellte Gehäuse 2 wird zur Prüfung des Chips in einen Testsockel 3 gesteckt. Falls erforderlich wird eine Nachbearbeitung des Gehäuses 2 oder Chips vorgenommen. Anschließend wird das Gehäuse 2 in ein Verpackungsmittel, z. B. eine Schiene 4, verpackt. Erst unmittelbar vor dem Bestücken einer Platine 5 mit dem Gehäuse 2 wird z.B. jedes zweite Anschlussbeinchen 12 mittels eines Biegewerkzeuges 6 nach innen gebogen, während die restlichen Anschlussbeinchen 11 unbearbeitet bleiben. Nun werden die Anschlussbeinchen 11 und 12 in die Bohrungen 7 der Platine 5 gesteckt, vorzugsweise mittels des Biegewerkzeuges 6.

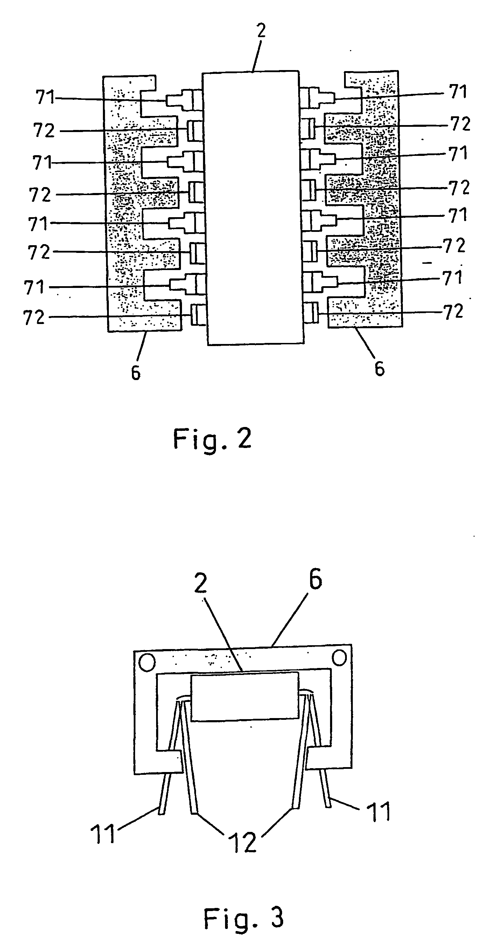

Figur 2 zeigt eine Draufsicht des Gehäuses 2 mit den Anschlussbeinchen 11 und 12 sowie mit dem aufgesetzten Biegewerkzeug 6.

Figur 3 zeigt das Gehäuse 2 mit den Anschlussbeinchen 11 und 12 sowie dem aufgestecktem Biegewerkzeug 6 in Frontansicht. Jedes zweite Anschlussbeinchen 12 ist nach innen gebogen, während die restlichen Anschlussbeinchen 11 wie bei der Herstellung des Gehäuses 2 nach außen gebogen sind oder senkrecht zum Gehäuse 2 stehen.

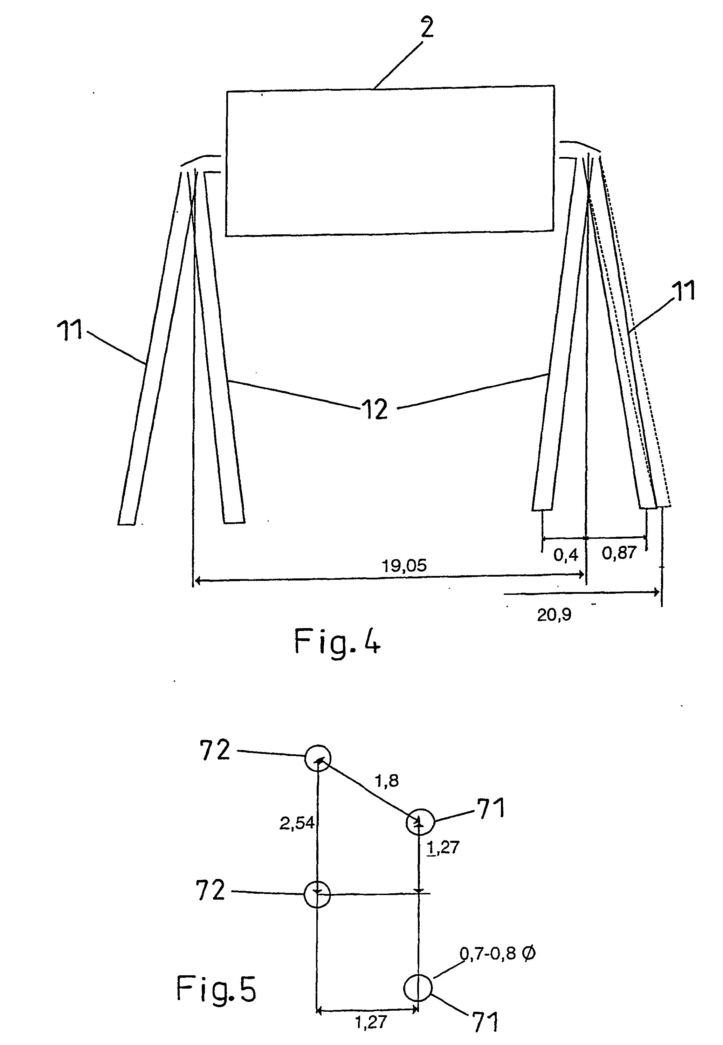

In Figur 4 ist eine Frontansicht des Gehäuses 2 mit den nach außen gebogenen Anschlussbeinchen 11 und den nach innen gebogenen Anschlussbeinchen 12 mit Maßangaben gezeigt.

Der Abstand zwischen den senkrechten der Anschlussbeinchen am Gehäuse beträgt 19,05 mm. Die zweiten Anschlussbeinchen 12 sind um 0,4 mm von der Senkrechten nach innen, und die restlichen Anschlussbeinchen 11 um 0,87 mm nach außen gebogen.

Figur 5 zeigt einen Ausschnitt einer Platine 5 mit Bohrungen 71 für die nach außen gebogenen Anschlussbeinchen 11 und mit Bohrungen 72 für die nach innen gebogenen Anschlussbeinchen 12. Die Bohrungen 71 und 72 sind um 1,27 mm gegeneinander versetzt. Der Abstand der jeweils auf einer geraden Linie liegenden Bohrungen 71 sowie 72 beträgt 2,54 mm. Der Abstand zwischen zwei gegeneinander versetzt angeordneten Bohrungen 71 und 72 ist zu 1,8 mm gewählt.

Besonders vorteilhaft ist es, die Anschlußbeinchen symmetrisch zur Längsmittelachse und zur Quermittelachse des Gehäuses am Gehäuse anzuordnen, weil diese symmetrische Anordnung den Einsatz eines symmetrischen Biegewerkzeuges ermöglicht. Es spielt daher keine Rolle, wie das Biegewerkzeug auf das Gehäuse aufgesetzt wird. Die Anschlußbeinchen können nicht mehr durch verdrehtes Aufsetzen des Biegewerkzeuges falsch gebogen werden.
Das erfindungsgemäße Verfahren ermöglicht z. B. den Einsatz von Verpackungsmittel, die für Standard-PSDIP-Gehäuse geeignet sind. Es sind keine besonderen Verpackungsmittel erforderlich.

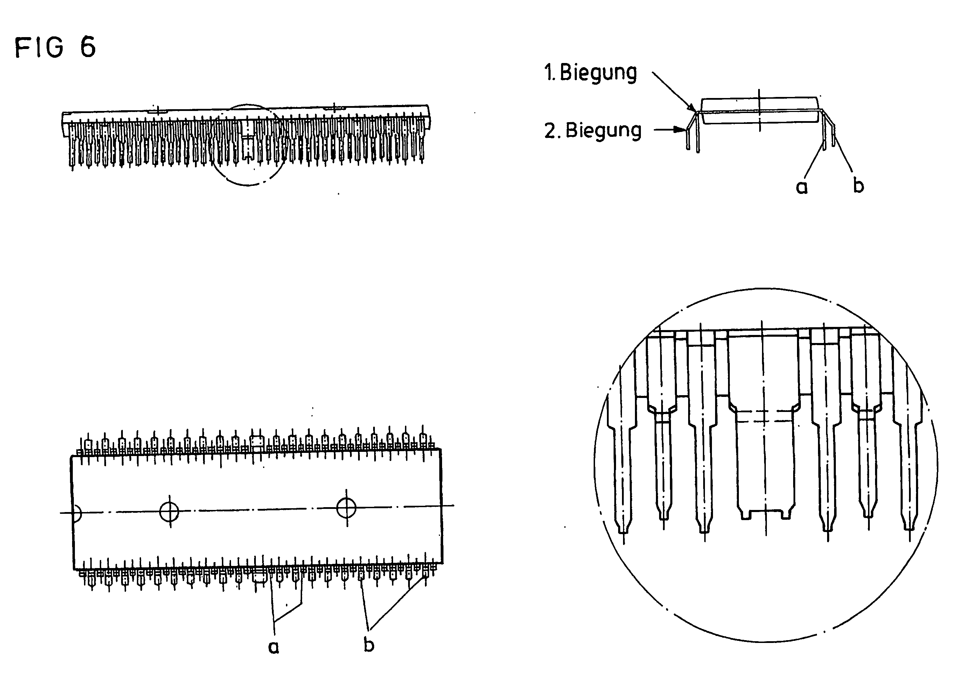

Während in den vorgenannten Figuren davon die Rede war, jedes zweite Anschlussbeinchen einmal nach innen zu biegen, ist in Figur 6 eine andere Möglichkeit beschrieben. Dort ist jedes 2. Beinchen a vom Gehäuse ausgehend um 90° nach unten gebogen. Jedes dazwischenliegende Beinchen b ist dagegen - ausgehend vom Gehäuse - erst um weniger als 90°, z.B. 45°, nach unten gebogen und dann um einen weiteren Winkel, z.B. 45°.

### Bezugszeichenliste

- 1: Anschlussbeinchen
- 2: Gehäuse
- 3: Testsockel
- 4: Schiene
- 5: Platine
- 6: Biegewerkzeug
- 7: Bohrung
- 11: nach außen gebogenes Anschlussbeinchen
- 12: nach innen gebogenes Anschlussbeinchen
- 71: Bohrung für nach außen gebogenes Anschlussbeinchen
- 72: Bohrung für nach innen gebogenes Anschlussbeinchen
- a: Beinchen
- b: Beinchen

## Patentansprüche

1. Verfahren zum Prüfen eines Chips mit einem Gehäuse (2) und zum Bestücken einer Platine (5) mit dem Gehäuse (2), wobei das Gehäuse (2) zwei parallele Reihen von Anschlussbeinchen (1) aufweist und wobei die Enden der Anschlussbeinchen (1) einer Reihe von Anschlussbeinchen (1) auf einer geraden Linie liegen, wobei zum Prüfen des Chips das Gehäuse (2) mit den Anschlussbeinchen (1) in einen Testsockel (3) gesteckt wird, wobei die Anschlussbeinchen (1) beim Einstecken in den Testsockel bereits derart gebogen sind, dass die Enden beider Reihen in einer Ebene liegen und wobei erst unmittelbar vor dem Einsetzen der Anschlussbeinchen (1) des Gehäuses (2) in die Bohrungen (7) der Platine (5) mindestens ein Anschlussbeinchen (12) mittels eines Biegewerkzeuges (6) nach innen gebogen wird, so dass die Anschlussbeinchen (11, 12) versetzt angeordnet werden,
**dadurch gekennzeichnet, dass**
jedes zweite Anschlussbeinchen (12) nach innen.gebogen wird, wobei die gegeneinander versetzten Anschlussbeinchen (11, 12) aus der Gehäuseebene um voneinander verschiedene Winkel abgebogen sind.

2. Verfahren nach Anspruch 2,
**dadurch gekennzeichnet, dass**
die nach innen gebogenen und die äußeren Anschlussbeinchen (11, 12) symmetrisch zur Längsmittelachse und zur Quermittelachse des Gehäuses (2) angeordnet werden.

3. Verfahren nach Anspruch 1 oder 2,
**dadurch gekennzeichnet, dass** der Abstand der auf einer geraden Linie liegenden Anschlussbeinchen (11) 1,27 mm und der Abstand der Bohrungen (71,72) auf der Platine (5) mindestens 1,788 mm beträgt.

4. Verfahren nach einem der vorangehenden Ansprüche,
**dadurch gekennezeichnet, dass** die Anschlussbeinchen (71, 72) um 1,27 mm gegeneinander versetzt sind.

5. Verfahren nach einem der vorangehenden Ansprüche ,
**dadurch gekennzeichnet, dass** jedes erste Anschlussbeinchen (11) um einen vorgebbaren ersten Winkel nach außen und jedes zweite Anschlussbeinchen (12) um einen vorgebbaren zweiten Winkel nach innen gebogen wird.

6. Verfahren nach einem der vorangehenden Ansprüche,
**dadurch gekennzeichnet, dass** das Gehäuse (2) mittels des Biegewerkzeuges (6) auf die Platine (5) gesteckt wird.

7. Chip mit einem Gehäuse (2) und mit nebeneinander liegenden Anschlussbeinchen (1) auf zwei gegenüberliegenden Seiten des Gehäuses (2), wobei jedes zweite Anschlussbeinchen (12) nach innen gebogen ist, so dass die Anschlussbeinchen (11, 12) versetzt angeordnet sind, wobei die Enden der nach innen gebogenen Anschlussbeinchen und die Enden der äußeren Anschlussbeinchen jeweils auf einer geraden Linie liegen,
**dadurch gekennzeichnet, dass**
die gegeneinander versetzten Anschlussbeinchen (11, 12) um voneinander verschiedene Winkel aus der Gehäuseebene abgebogen sind.

8. Chip mit einem Gehäuse nach Anspruch 7,
**dadurch gekennzeichnet, dass**
die nach innen gebogenen und die äußeren Anschlussbeinchen (11, 12) symmetrisch zur Längsmittelachse und zur Quermittelachse des Gehäuses (2) angeordnet sind.

9. Chip nach Anspruch 7 oder 8,
**dadurch gekennzeichnet, dass**
der Abstand der auf einer geraden Linie liegenden Anschlussbeinchen (11) 1,27 mm beträgt.

10. Chip nach einem der Ansprüche 7 bis 9,
**dadurch gekennezeichnet, dass** die Anschlussbeinchen (71, 72) um 1,27 mm gegeneinander versetzt sind.

11. Chip nach einem der Ansprüche 7 bis 10,
**dadurch gekennzeichnet, dass** jedes erste Anschlussbeinchen (11) um einen vorgebbaren ersten Winkel nach außen und jedes zweite Anschlussbeinchen (12) um einen vorgebbaren zweiten Winkel nach innen gebogen ist.

## Claims

1. A method for testing a chip with a housing (2) and for equipping a printed circuit board (5) with the housing (2), whereby the housing (2) comprises two parallel rows of connection legs (1) and whereby the ends of the connection legs (1) of a row of connection legs (1) lie in a straight line, whereby to test the chip the housing (2) with the connection legs (1) is placed into a test socket (3), whereby the connection legs (1) are already bent upon insertion into the test socket in such a manner that the ends of both rows lie in one plane and whereby at least one connection leg (12) is inwardly bent by means of a bending tool (6) only directly prior to the insertion of the connection legs (1) of the housing (2) into the bores (7) of the printed circuit board (5), so that the connection legs (11, 12) are offset,
**characterised in that** every second connection leg (12) is inwardly bent, with the offset connection legs (11, 12) being bent by different angles out of the plane of the housing.

2. A method according to Claim 2,
**characterised in that** the inwardly bent and the external connection legs (11, 12) are disposed symmetrically to the longitudinal centre axis and to the transversal centre axis of the housing (2).

3. A method according to Claim 1 or 2,
**characterised in that** the distance between the connection legs (11) lying in a straight line is 1.27 mm and the distance between the bores (71, 72) on the printed circuit board (5) is at least 1.788 mm.

4. A method according to one of the preceding Claims,
**characterised in that** the connection legs (71, 72) are offset in relation to each other by 1.27 mm.

5. A method according to one of the preceding Claims,
**characterised in that** every first connection leg (11) is outwardly bent by a predetermined first angle and every second connection leg (12) is inwardly bent by a predetermined second angle.

6. A method according to one of the preceding Claims,
**characterised in that** the housing (2) is placed onto the printed circuit board (5) by means of the bending tool (6).

7. A chip having a housing (2) and having adjacent connection legs (1) on two opposite sides of the housing (2), with every second connection leg (12) being inwardly bent so that the connection legs (11, 12) are offset, with the ends of the inwardly bent connection legs and the ends of the outer connection legs each lying on a straight line, **characterised in that** the offset connection legs (11, 12) are bent by different angles out of the plane of the housing.

8. A chip having a housing according to Claim 7,
**characterised in that** the inwardly bent and the outer connection legs (11, 12) are disposed symmetrically to the longitudinal centre axis and to the transversal centre axis of the housing (2).

9. A chip according to Claim 7 or 8,
**characterised in that** the distance between the connection legs (11) lying on a straight line is 1.27 mm.

10. A chip according to one of Claims 7 to 9,
**characterised in that** the connection legs (71, 72) are offset by 1.27 mm.

11. A chip according to one of Claims 7 to 10,
**characterised in that** every first connection leg (11) is bent inwardly by a predetermined first angle and every second connection leg (12) is bent outwardly by a predetermined second angle.

## Revendications

1. Procédé pour tester une puce pourvue d'un boîtier (2) et de mise en place du boîtier (2) sur une carte de circuit imprimé (5), dont le boîtier (2) présente deux rangées parallèles de languettes de contact (1) et les extrémités des languettes de contact (1) d'une rangée de languettes de contact (1) se situent sur une ligne droite, le boîtier (2) avec les languettes de contact (1) est inséré dans une embase de test (3) pour tester la puce, les languettes de contact (1) sont déjà pliées pour l'insertion dans l'embase de test de telle sorte que les extrémités des deux rangées se situent sur un même plan, et au moins une languette de contact (12) est pliée vers l'intérieur au moyen d'un outil de pliage (6) juste avant l'insertion des languettes de contact (1) du boîtier (2) dans les perçages (7) de la carte de circuit imprimé (5) de telle sorte que les languettes de contact (11, 12) se trouvent décalées,
**caractérisé en ce que**
une languette de contact (12) sur deux est pliée vers l'intérieur, les languettes de contact (11, 12) décalées les unes par rapport aux autres étant pliées à partir du plan de boîtier d'angles différents les uns des autres.

2. Procédé selon la revendication 2,
**caractérisé en ce que**
les languettes de contact (11, 12) extérieures et celles pliées vers l'intérieur sont disposées de façon symétrique par rapport à l'axe médian longitudinal et à l'axe médian transversal du boîtier (2).

3. Procédé selon la revendication 1 ou 2,
**caractérisé en ce que**
la distance entre les languettes de contact (11) situées sur une ligne droite est de 1,27 mm et la distance entre les perçages (71, 72) sur la carte de circuit imprimé (5) est d'au moins 1, 788 mm.

4. Procédé selon l'une quelconque des revendications précédentes,
**caractérisé en ce que**
les languettes de contact (71, 72) sont décalées les unes des autres de 1,27 mm.

5. Procédé selon l'une quelconque des revendications précédentes,
**caractérisé en ce que**
chaque première languette de contact (11) est pliée d'un premier angle prédéterminé vers l'extérieur et chaque deuxième languette de contact (12) d'un deuxième angle prédéterminé vers l'intérieur.

6. Procédé selon l'une quelconque des revendications précédentes,
**caractérisé en ce que**
le boîtier (2) est inséré sur la carte de circuit imprimé (5) au moyen de l'outil de pliage (6).

7. Puce avec un boîtier (2) et des languettes de contact (1) juxtaposées sur deux faces opposées du boîtier (2), pour laquelle chaque deuxième languette de contact (12) est pliée vers l'intérieur de telle sorte que les languettes de contact (11, 12) se trouvent décalées, et les extrémités des languettes de contact pliées vers l'intérieur ainsi que les extrémités des languettes de contact extérieures se situent respectivement sur une ligne droite,
**caractérisée en ce que**
les languettes de contact (11, 12) décalées les unes par rapport aux autres sont pliées à partir du plan de boîtier d'angles différents les uns des autres.

8. Puce avec un boîtier selon la revendication 7,
**caractérisée en ce que**
les languettes de contact (11, 12) pliées vers l'intérieur et extérieures sont disposées de façon symétrique par rapport à l'axe médian longitudinal et l'axe médian transversal du boîtier (2).

9. Puce selon la revendication 7 ou 8,
**caractérisée en ce que**
la distance entre les languettes de contact (11) situées sur une ligne droite est de 1,27 mm.

10. Puce selon l'une quelconque des revendications 7 à 9,
**caractérisée en ce que**
les languettes de contact (71, 72) sont décalées les unes par rapport aux autres de 1,27 mm.

11. Puce selon l'une quelconque des revendications 7 à 10,
**caractérisée en ce que**
chaque première languette de contact (11) est pliée d'un premier angle prédéterminé vers l'extérieur et chaque deuxième languette de contact (12) d'un deuxième angle prédéterminé vers l'intérieur.
